# EUROPEAN PATENT SPECIFICATION

(11) **EP 0 481 493 B1**
(45) Date of publication and mention of the grant of the patent: **07.02.1996**
(21) Application number: 91117759.0
(22) Date of filing: 17.10.1991
(51) Int. Cl.: H01H 85/06, H01H 85/02

(54) **Fuse Conductor**
Schmelzleiter
Conducteur fusible

(30) Priority: 18.10.1990 JP 281033/90; 18.10.1990 JP 281034/90; 19.11.1990 JP 315500/90; 26.09.1991 JP 247984/91; 26.09.1991 JP 247985/91
(43) Date of publication of application: 22.04.1992
(73) Proprietor: SUMITOMO ELECTRIC INDUSTRIES, LIMITED, Osaka 541 (JP)
(72) Inventor: Nishio, Masanobu, c/o Osaka Works, Konohana-ku, Osaka (JP)
(74) Representative: Kirschner, Klaus Dieter, Dipl.-Phys.

(56) References cited:
- EP-A- 0 232 868
- EP-A- 0 364 981
- CH-A- 553 478
- DE-A- 3 033 323
- DE-A- 3 245 629
- FR-A- 2 106 538
- GB-A- 1 179 518
- US-A- 3 913 051

## Description

The present invention relates to a fuse conductor which is instantaneously broken when an excess current flows beyond the rated value. More particularly, it relates to a fuse conductor which is integrated into a semiconductor device such as IC, a transistor or the like, or a circuit component such as a capacitor, to open a circuit when an excess current flows to such a device or component, thereby preventing the same from burning.

The present invention also relates to a fuse conductor which is applied to a fuse element or directly interconnected with a lead wire part of a circuit, in order to prevent an excess current.

### Description of the Background Art

A conventional fuse conductor is prepared from Pb, Zn, a Pb-Sn alloy or the like, as described in "Kinzoku Binran" edited by Nihon Kinzoku Gakkai, Fourth Edition revised on December 20, 1982, p. 1007. A fuse conductor of such a metal or alloy is melted by Joule heat of an excess current, to open an electric circuit. In order to precisely decide a fusing current regardless of the outside air temperature, such a fuse conductor may be formed by a tungsten wire. Further, a fuse conductor to be melted upon overheating of a heating atmosphere is prepared from a Wood's metal, which is melted at a low temperature.

Japanese Patent Laying-Open No. 2-106807 (1990) and U.S. Patent No. 5,019,457 describe a Pb-Ag alloy, which is known as a material for a fuse conductor to be contained in a semiconductor device or an electronic component.

However, it has been difficult to draw such a conventional fuse conductor into an extra fine wire, which can provide a fuse function to a semiconductor device or a circuit component. Therefore, another apparatus having a fuse function is integrated into such a device or component, to provide the fuse function. Although a fuse conductor to be contained in a semiconductor device or an electronic component is put into practice in some quarter, a large fusing current is required for melting such a fuse conductor. Thus, awaited is a fuse conductor which is melted at a smaller fusing current.

DE-A-3 033 323 describes a fuse conductor comprising a central conductor and a coating layer, the central conductor being made of Au and the coating layer being made of Ag.

EP-A-0 232 868 discloses a fused solid electrolytic capacitor comprising a first and a second conductive layer.

EP-A-0 364 981 relates to a overcurrent preventive diode wherein a fusing wire is made of a metal selected from a group consisting of gold, silver, copper and aluminum

### SUMMARY OF THE INVENTION

An object of the present invention is to provide a fuse conductor which is melted at a small fusing current and can be contained in a circuit component such as a capacitor, or a semiconductor device such as IC, a transistor or the like.

Another object of the present invention is to provide a fuse conductor which is applied to a fuse element or directly interconnected in a circuit, for preventing an excess current.

A fuse conductor according to the present invention is defined in claim 1. Preferred embodiments are defined in the subclaims.

The fuse conductor according to the present invention, is excellent in drawability and can be worked into a wire diameter smaller than that of a conventional fuse conductor.

According to the present invention, the wire diameter of the fuse conductor is set in the range of 0.02 to 0.10 mm. If the wire diameter exceeds 0.10 mm, the value of a current required for melting the fuse conductor is so increased that an armoring case and a substrate may be undesirably scorched. If the wire diameter is less than 0.02 mm, on the other hand, it is industrially difficult to work the fuse conductor. Further, it is difficult to handle a fuse conductor of less than 0.02 mm in wire diameter to integrate the same into a circuit component such as a capacitor.

The fuse conductor according to the present invention, which is prepared from a material having excellent drawability, can be worked into a fine wire or an extra fine wire. Thus, it is possible to obtain a fuse conductor which has an excellent prearcing time-current characteristic. Therefore, the inventive fuse conductor is effectively applied to a field which requires a high resistance value as well as a fine wire or an extra fine wire. In particular, the inventive fuse conductor is suitably contained in a circuit component such as a capacitor, or a semiconductor device such as IC, a transistor or the like.

Further, the inventive fuse conductor is also applicable to a fuse element or a fuse conductor providing a fuse function in a part of a circuit which is formed on a substrate.

The inventive fuse conductor is particularly usefully contained in a tantalum chip capacitor, which may be burned when a circuit component is erroneously integrated thereinto. Since the inventive fuse conductor can be thus contained in a semiconductor device or a circuit component, it is not necessary to integrate an extra apparatus having a fuse function into an electronic device independently of such a semiconductor device or circuit component, dissimilarly to the conventional case. Thus, it is possible to reduce the number of components, as well as to manufacture an electronic device having high reliability.

Further, the inventive fuse conductor may be applied to a conductor providing a fuse function in a circuit, which is formed on a substrate, to require no conventional fuse element.

A fuse conductor according to the present invention comprises a central conductor and a coating layer.

The material for the central conductor has excellent drawability. With respect to a Cu alloy, it is possible to improve tensile strength and electrical resistance by adding a proper amount of Sn as an alloying element. In this case, the amount of Sn to be added is preferably in a range of 0.3 to 10 %. If the amount exceeds 10 %, drawability is so reduced that it is difficult to work the fuse conductor into an extra fine wire. If the amount is less than 0.3 %, on the other hand, tensile strength and electrical resistance are not much improved.

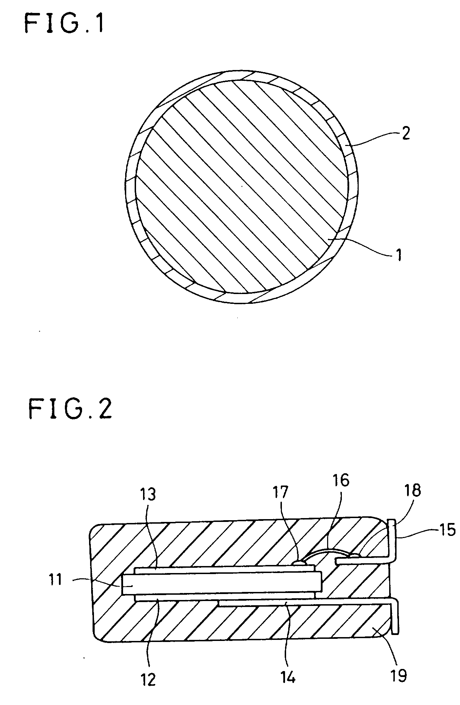

Fig. 1 is a sectional view showing an embodiment of a fuse conductor according to the present invention. Referring to Fig. 1, the fuse conductor according to the present invention comprises a coating layer 2 which is provided around a central conductor 1. The coating layer 2 can be provided around the central conductor 1 by electroplating or hot dipping, for example. According to the present invention, the surface layer is made of Ag.

The thickness of the surface layer is preferably in a range of 0.5 to 10 µm. If the thickness of the surface layer is less than 0.5 µm, it may be impossible to attain a sufficient effect of solderability. If the thickness of the surface layer exceeds 10 µm, on the other hand, the cost is increased while improvement of solderability following such increase of the thickness is undesirably saturated in view of economy.

The wire diameter of the fuse conductor according to the present invention is set in the range of 0.02 to 0.10 mm. If the wire diameter exceeds 0.10 mm, the value of a fusing current required for melting the fuse conductor is so increased that an armoring case and a substrate may undesirably be scorched. If the wire diameter is less than 0.02 mm, on the other hand, it is difficult to industrially work the fuse conductor. Even if the fuse conductor can be worked into a diameter of less than 0.2 mm, it is difficult to handle this fuse conductor to integrate the same into a circuit component such as a capacitor.

The fuse conductor according to the present invention, which has a surface layer of of Ag, has excellent solderability. Further, the inventive fuse conductor has an excellent prearcing time-current characteristic since its wire diameter is in the range of 0.02 to 0.10 mm. Thus, the fuse conductor according to the present invention can be effectively applied to a field which requires a high resistance value as well as a fine wire or an extra fine wire.

The inventive fuse conductor can be particularly effectively applied to a semiconductor device such as IC, a transistor or the like, or a circuit component such as a capacitor. In particular, the inventive fuse conductor is effectively applied to a conductor to be contained in a tantalum chip capacitor, which may be burned if a circuit component is erroneously integrated thereinto. Further, the inventive fuse conductor is also applicable to a fuse element, or a fuse conductor providing a fuse function in a part of a circuit which is formed on a substrate.

Thus, the fuse conductor according the present invention is so employed that it is not necessary to prepare an extra apparatus having a fuse function, which has generally been integrated into an electronic device independently of a semiconductor device or a circuit component.

Thus, it is possible to reduce the number of components by employing the fuse conductor according to the present invention, to enable manufacturing of an electronic device having high reliability. Further, the inventive fuse conductor may be applied to a conductor providing a fuse function in a circuit which is formed on a substrate, so that no conventional fuse element is required.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a sectional view showing an embodiment according to the present invention; and
Fig. 2 is a sectional view showing a capacitor containing a fuse conductor according to another embodiment of the present invention.

### DESCRIPTION OF THE PREFERRED EMBODIMENTS

Examples 1 to 3 according to the first aspect of the present invention are now described.

### Example 1

Alloys and pure metals having compositions shown in Table 1 were cast by a fusion casting method. The as-formed ingots were forged and drawn to prepare samples Nos. 1 to 10 of pure metal wires and alloy wires having wire diameters shown in Table 1 respectively.

Prescribed dc currents were fed to the as-formed pure metal wires and alloy wires, to evaluate prearcing time-current characteristics by measuring the minimum fusing currents required for melting the wires within 1 second. The prearcing time-current characteristics are improved as the fusing currents are reduced. In this test, the alloy wires and the pure metal wires were integrated into prescribed circuits, with fuse lengths of 2 mm. The minimum fusing currents, which were required for melting the inventive samples Nos. 1 to 10 within 1 second, were in a range of 1.0 to 9.5 A.

On the other hand, comparative samples Nos. 11, 12 and 13 were prepared from a copper wire, a silver wire and a gold wire, whose wire diameters were in excess of the range of the present invention, respectively. All such comparative samples required fusing currents of at least 10 A. Thus, the metal wires of the comparative samples Nos. 11 to 13 were unsuitable for integration into a semiconductor device or a circuit component.

While an attempt was made to prepare fine wires from lead, zinc and a lead-tin alloy, i.e., materials which have been generally employed for fuse conductors, it was impossible to work such materials into 0.1 mm in wire diameter.

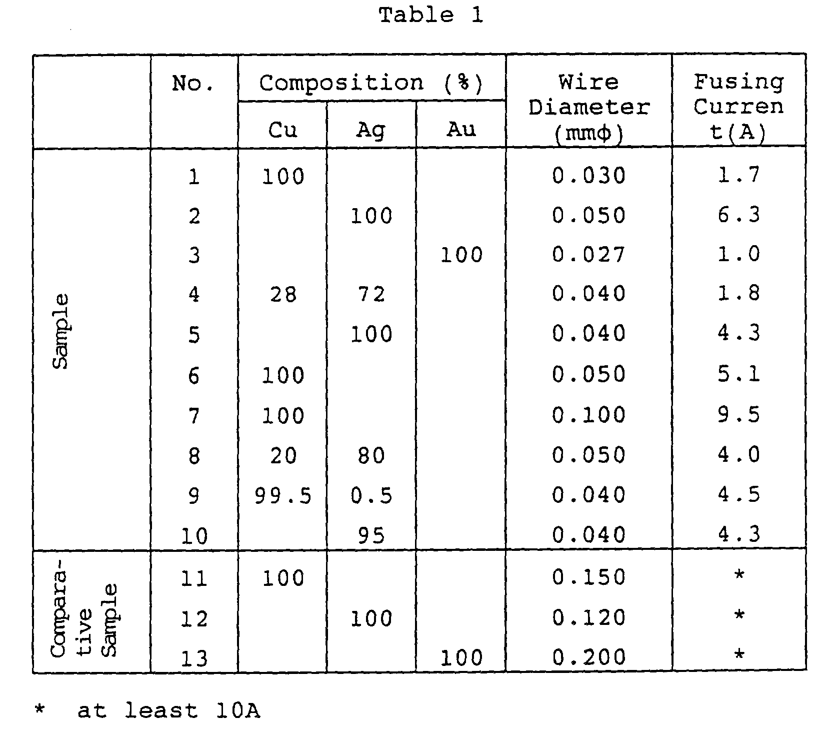

### Example 2

An Ag-28%Cu alloy, which was similar in composition to the sample No. 4 of Example 1 shown in Table 1, was drawn into 50 µm in wire diameter in a similar manner to Example 1. The as-formed alloy wire exhibited tensile strength of 100 kg/mm, and a fusing current, i.e., the minimum current required for melting the wire within 1 second, of 3.5 A. This alloy wire was contained in a capacitor, to serve as a fuse conductor.

Fig. 2 is a sectional view showing a capacitor which contains such a fuse conductor. Referring to Fig. 2, electrodes 12 and 13 are provided on both sides of a dielectric member 11. An end of a lead wire 14 is connected to the electrode 12. A fuse conductor 16 of the aforementioned alloy wire is electrically connected between an end of another lead wire 15 and the electrode 13 by solder means 17 and 18 respectively. The entire capacitor is sealed with resin 19. When a current five times the value of the rated current was fed to this capacitor, only the fuse conductor 16 was broken with no damage to other electric circuits including the capacitor.

As clearly understood from the above description, the alloy wire of Example 2 is suitable as a fuse conductor which is contained in a capacitor.

### Example 3

A fuse wire of 50 µm in wire diameter, which was No. 9 shown in Table 1, was interconnected with a part of a lead wire provided on an input side of a transformer with a length of 30 mm, to form a circuit. When a current of 3 A, which was three times the value of the rated current, was fed to this transformer, the fuse wire was melted within 1 second, to prevent the transformer from burning.

As clearly understood from the above description, the fuse wire according to the present invention can simplify the structure of a fuse circuit, which has generally been formed by a fuse tube, a holder and the like, to attain a compact configuration.

Examples 4 to 7 are now described.

### Example 4

Coating layers of gold, silver, tin, eutectic solder and the like were formed around central conductors of 0.7 mm in wire diameter by plating or cladding, as shown in Table 2. The as-formed wires were further worked into prescribed wire diameters, and subjected to evaluation of prearcing time-current characteristics and solderability.

The prearcing time-current characteristics were evaluated from the minimum fusing currents, which were required for melting the wires within 1 second. The required for melting the wires within 1 second. The prearcing time-current characteristics are improved as the fusing current values are reduced. In this test, the fuse conductors were integrated into prescribed circuits, with fuse lengths of 2 mm.

Further, solderability was evaluated through zero cross times (ZCT) in a meniscograph method, as follows:

Evaluation of Solderability
A: excellent in solderability with ZCT of 0 to 1 sec.
B: solderable with ZCT of 1 to 1.5 sec.
C: hard to attain soldered connection with ZCT of ≧ 1.5 sec. 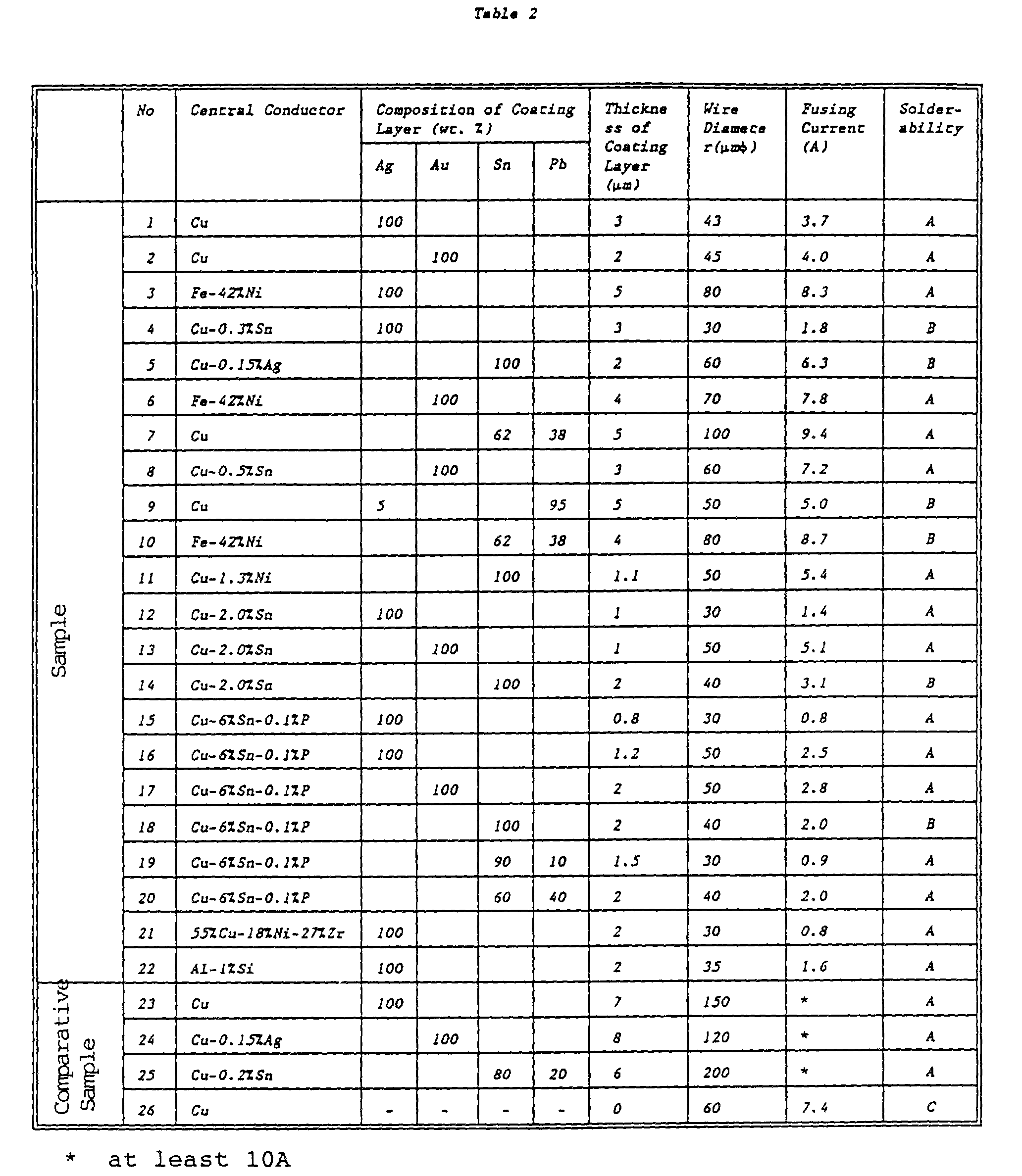 only fuse conductors with a central conductor made of a Cu alloy containing at least 2% of Sn or 1.3% of Ni a coating layer made of Ag and having a wire diameter being in a range of 0.02 to 0.10 mm, are claimed in the present invention.
As clearly understood from Table 2, it was easy to work the alloy wires and pure metal wires of samples Nos. 1 to 22 into wire diameters in a range of 30 to 100 µm, and the minimum fusing currents required for melting the samples within 1 second were in a range of 0.8 to 9.4 A. Further, these samples were excellent in solderability.

On the other hand, comparative samples Nos. 23 to 25 were prepared from fuse conductors whose wire diameters were in excess of the range of the present invention. As understood from Table 2, all such comparative samples required large fusing currents, and were improper as fuse conductors to be contained in a semiconductor device or a circuit component.

Still another comparative sample No. 26 was prepared from a fuse conductor which was provided with no surface layer, and subjected to evaluation of a fusing current and solderability. This sample was extremely inferior in solderability.

### Example 5

A Cu-0.3%Sn alloy plated with Ag was drawn into 30 µm in wire diameter similarly to the sample No. 4 shown in Table 2, to prepare a fuse conductor to be contained in the capacitor shown in Fig. 2. This fuse conductor exhibited tensile strength of 60 kg/mm and a fusing current, i.e., the minimum current which was required for melting the fuse conductor within 1 second, of 1.8 A.

When a current five times the value of the rated current was fed to the capacitor containing the aforementioned fuse conductor, only the fuse conductor was broken with no damage to other electric circuits including the capacitor.

As clearly understood from this, the fuse conductor according to the present invention is suitably contained in a capacitor.

### Example 6

A fuse conductor of 30 µm in wire diameter, which was similar in composition to the sample No. 15 shown in Table 2, was employed to prepare a chip-type fuse. Both ends of this fuse were connected to a lead frame by resistance welding. When a current three times the value of the rated current was fed to this chip-type fuse, the fuse was melted within 1 second.

### Example 7

A fuse wire of 60 µm in wire diameter having the same composition as the sample No. 15 shown in Table 2 was interconnected with a part of a lead wire provided on an input side of a transformer, to form a circuit. When a current of 1.5 A was fed to this transformer, the fuse was melted within 1 second, to prevent the transformer from burning.

While a fuse circuit has generally been formed by a fuse tube, a holder and the like, the structure of a fuse portion can be simplified by employing the fuse wire according to the present invention, to attain a compact configuration.

Although the present invention has been described and illustrated in detail, it is clearly understood that the same is by way of illustration and example only and is not to be taken by way of limitation, the scope of the present invention being limited only by the terms of the appended claims.

## Claims

1. A fuse conductor comprising a central conductor (1) and a coating layer (2), said central conductor (1) being made of a Cu alloy containing at least 2% of Sn or 1.3% of Ni; said coating layer (2) being made of Ag; and said fuse conductor having a wire diameter being in a range of 0.02 to 0.10 mm.

2. A fuse conductor in accordance with claim 1, including a fuse conductor to be contained in a capacitor.

3. A fuse conductor in accordance with claim 1, including a fuse conductor to be contained in a semiconductor device.

4. A fuse conductor in accordance with claim 1, including a fuse conductor to be contained in a fuse element.

5. A fuse conductor in accordance with claim 1, including a fuse conductor providing a fuse function in a part of a circuit which is formed on a substrate.

## Patentansprüche

1. Schmelzleiter mit einem Mittelleiter (1) und einer Überzugsschicht (2), wobei der Mittelleiter (1) aus einer Cu-Legierung mit mindestens 2% Sn oder 1,3% Ni gefertigt ist;
die Überzugsschicht (2) aus Ag ist; und der Schmelzleiter einen Drahtdurchmesser in einem Bereich von 0,02 bis 0,10 mm aufweist.

2. Schmelzleiter nach Anspruch 1, umfassend einen Schmelzleiter, der dazu bestimmt ist, in einem Kondensator enthalten zu sein.

3. Schmelzleiter nach Anspruch 1, umfassend einen Schmelzleiter, der dazu bestimmt ist, in einer Halbleitereinrichtung enthalten zu sein.

4. Schmelzleiter nach Anspruch 1, umfassend einen Schmelzleiter, der der dazu bestimmt ist, in einem Schmelzelement enthalten zu sein.

5. Schmelzleiter nach Anspruch 1, mit einem Schmelzleiter, der eine Schmelzfunktion in einem Teil eines Schaltkreises liefert, der auf einem Substrat gebildet ist.

## Revendications

1. Conducteur fusible comprenant un conducteur central (1) et une couche de revêtement (2), ce conducteur central (1) étant réalisé à partir d'un alliage Cu contenant au moins 2% de S, ou 1,3% de Ni;
cette couche de revêtement (2) étant réalisée en Ag; et ce conducteur fusible ayant un diamètre de fil dans la plage de 0,02 à 0,10 mm.

2. Conducteur fusible selon la revendication 1, comprenant un conducteur fusible devant être logé dans un capaciteur.

3. Conducteur fusible selon la revendication 1, comprenant un conducteur fusible devant être logé dans un dispositif à semi-conducteurs.

4. Conducteur fusible selon la revendication 1, comprenant un conducteur fusible devant être logé dans un élément fusible.

5. Conducteur fusible selon la revendication 1, comprenant un conducteur fusible assurant une fonction de fusible dans une partie de circuit qui est réalisée sur un substrat.
